Europäisches Patentamt

(19) European Patent Office                    (11) Publication number:          **0 083 503**

Office européen des brevets                                            **B1**

(12)                          EUROPEAN PATENT SPECIFICATION

(45) Date of publication of patent specification: **01.03.89**          (51) Int. Cl.⁴: **H 01 R 4/04**

(21) Application number: **82306966.1**

(22) Date of filing: **24.12.82**

(54) Insulated connector sheet.

(30) Priority: **28.12.81 US 334821**

(43) Date of publication of application:
**13.07.83 Bulletin 83/28**

(45) Publication of the grant of the patent:
**01.03.89 Bulletin 89/09**

(84) Designated Contracting States:
**AT DE FR GB IT NL SE**

(56) References cited:
**DE-A-2 758 491**
**GB-A-2 048 582**
**US-A-3 475 213**
**US-A-3 514 326**
**US-A-4 113 981**
**US-A-4 139 675**
**US-A-4 258 100**

(73) Proprietor: **MINNESOTA MINING AND
MANUFACTURING COMPANY**
**3M Center, P.O. Box 33427**
**St. Paul, Minnesota 55133-3427 (US)**

(72) Inventor: **Reylek, Robert S.**
**2501 Hudson Road P. O. Box 33427**
**St. Paul Minnesota 55133 (US)**
Inventor: **Berg, James G.**
**2501 Hudson Road P. O. Box 33427**
**St. Paul Minnesota 55133 (US)**

(74) Representative: **Baillie, Iain Cameron et al**
**c/o Ladas & Parry Isartorplatz 5**
**D-8000 München 2 (DE)**

Courier Press, Leamington Spa, England.

## Description

Technical field

This invention relates to sheet materials useful for making adhesive and electrical connections to electronic components.

Background art

There is a need in the electronic equipment industry for means for making convenient and secure electrical connections to sets of small side-by-side terminal pads, such as the terminal pads of a printed circuit board or a liquid crystal display. A promising technique for making such connections is taught in the GB—A—2,048,582, which teaches an adhesive connector tape comprising a flexible insulative sheet, a plurality of parallel, separated, electrically conductive stripes carried on the sheet, and an electrically conductive adhesive covering the conductive stripes. Electrical connections can be made by adhering an end of the tape against a set of terminal pads, with individual stripes on the tape in alignment with individual pads.

For satisfactory use of sheet material as described, the electrically conductive adhesive in the sheet material must achieve a low-resistance bond that is stable for the length of time and under the operating conditions that are expected for the sheet material. Conventional electrically conductive adhesives have not provided the needed degree of stability and low resistance. Initial resistance is too high and/or resistance increases during use, to the extent that mechanical clamping techniques are often used to supplement the adhesive bond.

Also, a disadvantage of the described connector tape is that the electrically conductive adhesive covering the stripes can unintentionally be brought into contact with other members of an electronic assembly at intermediate portions along the length of the tape, thus introducing undesired electrical connections into the assembly. Such unintentional contacts could be avoided by covering the intermediate portion of the tape with an insulating layer, as has been done with some miniature flat cables of the prior art (see U.S. Pat. 4,113,981 which describes a cable comprising a flat sheet carrying electrically conductive stripes). However, such an intermediate covering of a cable is inconvenient and uneconomic, since it requires applying insulating material in specific lengths for specific uses. Application in specific lengths is a more difficult operation, and it requires maintaining an inventory of cables of different insulated lengths for different jobs. Alternatively, insulation must be removed from the end portions of the cable, which is difficult and not adapted to speedy automated operations.

Disclosure of invention

The invention is indicated in the independent claims 1, 3 and 15.

The present invention provides a new electrically conductive adhesive sheet material which in preferred embodiments is insulated over its full adhesive surface and yet can be directly bonded and electrically connected to an electronic component in one operation. In one form this new product includes an electrically conductive layer, such as a layer of metal vapor-coated onto an insulating sheet, to provide electrical conductivity in the plane of the sheet material. In other forms such a conductive layer is omitted, and the adhesive sheet material is a "transfer" adhesive, which may be applied between adherends that have such conductive layers, or adhered to a tape having such a conductive layer, etc.

In both forms, sheet material of the invention generally comprises a polymeric or adhesive layer in which are dispersed a monolayer of discrete separated electrically conductive elements, such as metal particles, which are substantially as thick as or thicker than the layer. A thin electrically insulating layer is disposed over the monolayer of electrically conductive elements and comprises an electrically insulating material which is nontacky or poorly tacky at room temperature (i.e., 20°C.), provides an electrical resistance through the layer to the electrically conductive elements of at least about one megohm in the test described herein, softens to an adhesive and flowable condition upon heating to an elevated temperature, and upon cooling to room temperature resumes a firm and substantially nonflowable condition. The described sheet material is readily handleable and free from conductive bonding at room temperature, but, it may be pressed against a substrate and heated to make a bonded connection in which the electrically conductive elements extend through the insulating layer into electrical connection with the substrate.

The polymeric or adhesive layer in which the electrically conductive elements are dispersed is generally carried on a flexible backing, and one or more electrically conductive layers may also be carried on the backing or may constitute the backing. The adhesive layer preferably softens to an adhesive condition upon heating to an elevated temperature, and subsequently hardens to exhibit a firm and substantially nonflowable condition at room temperature. And the electrically conductive elements dispersed in the adhesive layer preferably have an average thickness greater than the average thickness of the adhesive layer, with the top edge of substantially each element being higher than at least part of the exterior surface of the adhesive layer surrounding the element.

During bonding of the described preferred sheet material to a substrate, the adhesive around a conductive element is pressed into contact with the substrate and forms an adhesive bond to the substrate. The backing, on which the adhesive layer is carried, is also pressed toward the substrate and conforms around the conductive element, which is thicker than the adhesive layer. The backing appears to be held in tension around the conductive element and to place the conductive element under compression against the substrate. With the adhesive layer in a firm and substantially nonflowable condition and with the electrically conductive elements held against the substrate, connections are formed that have low resistance and maintain that low resistance over a long useful life.

The utility of sheet material of the invention contrasts with previous experience with commercial pressure-sensitive adhesive connector tape products of the type described in U.S. Pat. 3,475,213. Those tapes use a pressure-sensitive adhesive layer coated onto an electrically conductive backing, typically a metal foil, with a monolayer of relatively large particles dispersed in the adhesive layer. The particles in these tapes were substantially the same thickness as the adhesive layer and sometimes were more thick than the adhesive layer. However, these tapes do not always achieve low-resistance electrical connections unless clamps are used to hold the tape against a substrate. Apparently, the force holding the particle against the substrate gradually decreases after the tape has been adhered in place as a result of flow of the adhesive.

Despite such prior experience, preferred sheet material of the invention incorporates a layer of an insulating material in sufficient thickness to provide electrical insulation and physical protection, and yet reliable and secure electric connections can be made through the insulating layer using heat and pressure. The heat and pressure cause the insulating material to be displaced from over the electric conductors, and the insulating material is retained in its displaced position by the cooling of the insulating material to a firm condition. A low-resistance electric connection is formed, which is retained over a long useful life.

Typically, sheet material of the invention takes the form of an elongated tape which is wound upon itself in roll form for convenience in storage and use. Also, a plurality of electrically conductive layers are typically included as narrow parallel elongated stripes, with the stripes supported on an elongated insulating web, laterally spaced from one another, and extending the length of the insulating web. Connections are thus conveniently made between terminal substrates which comprise a plurality of separated side-by-side terminal pads. However, other configurations of conductive stripes or paths besides parallel stripes are used in some embodiments of sheet material of the invention for special applications.

Brief description of drawings

Figure 1 is an enlarged perspective view of an end portion of an illustrative electrical connector tape of the invention;

Figure 2 is a sectional view through the illustrative electrical connector tape of the invention shown in Figure 1; and

Figures 3—5 are sectional views through different illustrative electrical connector tapes of the invention.

Best mode for carrying out the invention

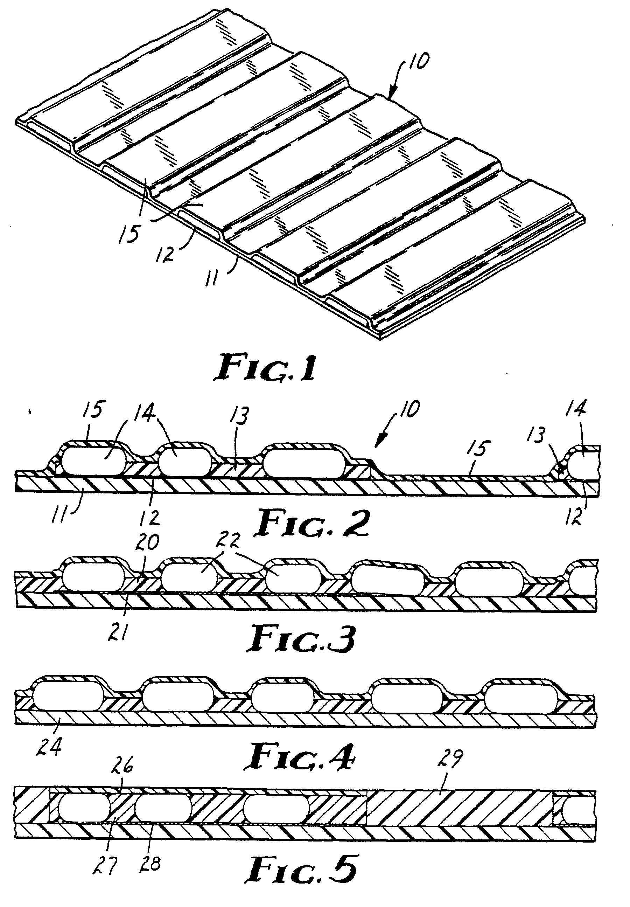

The illustrative tape 10 shown in Figures 1 and 2 comprises a flat electrically insulating sheet 11, electrically conductive stripes 12, a non-conductive adhesive material 13 coated over the conductive stripes, electrically conductive particles 14 dispersed in the adhesive material, and a thin layer 15 of electrically insulating material coated over the whole top surface of the tape.

The flat electrically insulating sheet 11 typically comprises a film, such as a film of polyethylene terephthalate or polyimide, or a resin-impregnated fibrous web. In preferred constructions, the sheet should be flexible so that it will conform around the electrically conductive elements during a bonding operation and allow the adhesive carried on the backing to contact the substrate to which a bond is being made. Preferred films have a flexibility on the order of a 25- or 50-micrometer thick film of polyethylene terephthalate. However, less flexible films can be used, generally by using greater pressure during a bonding operation and by using somewhat thicker adhesive layers, so that the film need not conform as greatly as it does with thinner adhesive layers.

The electrically conductive stripes 12 typically comprise a layer of metal, such as silver, gold, aluminum, or copper vapor-deposited onto the flat sheet. Other conductive layers can be used instead, such as a metal foil (which may constitute the whole backing or may be adhered to the flat sheet with adhesive), or a layer of metal sputtered onto the flat sheet, or a layer formed from a conductive coating composition or ink, typically comprising a coating vehicle and conductors such as metal or carbon particles.

The adhesive material 13 is a heat-activated material which forms an adhesive bond during a heating operation. During the heating operation the adhesive material wets out a substrate to which adhesion is to be made. Subsequently, either by cooling or reaction of the ingredients, the adhesive hardens and sheet material of the invention and conductive particles are held in place with respect to an adherend. At this point the adhesive material is either nontacky or poorly tacky.

A preferred adhesive material, known as a "hot-tackifying adhesive," is nontacky or poorly tacky at 20°C, but becomes pressure-sensitive and aggressively tacky when heated. Good bonds are immediately formed at a tackifying temperature without any need for crosslinking or other chemical reactions. The adhesive material comprises an acrylic polymer or mixture of acrylic polymers of at least one alkyl acrylate and/or methacrylate ester monomer (here called "acrylic ester monomer"), and differs from prior art adhesive materials in that:

1) acrylic ester monomer provides at least 50 mol percent of the one or more acrylic polymers of the adhesive layer,

2) said one or more acrylic polymers have a $T_g$ (glass transition temperature) or a weight-averaged $T_g$ of −10° to 80°C,

3) a layer of the adhesive material has

a) a Probe Tack Value (as defined below) of less than 75 grams of force (gf) at 20°C,

b) Probe Tack Values of at least 75 gf over a range of at least 50°C, which values remain substantially constant after 30 days at 40°C, and

c) a Shear Value (as defined below) of at least 25 minutes at 65°C, and

4) up to 50 mol percent of the one or more acrylic polymers can be provided by copolymerizable monomer having a polar group, such as acrylic acid, methacrylic acid, itaconic acid, maleic acid or anhydride, the amides of said acids, acrylonitrile, methacrylonitrile, and N-vinyl-2-pyrrolidone.

The one or more acrylic polymers may be a homopolymer of an acrylic ester monomer which provides a $T_g$ within the range of −10° to 80°C, e.g., methyl acrylate, or a copolymer of acrylic ester monomer and copolymerizable polar monomer having a $T_g$ within that range. Useful acrylic ester monomers which homopolymerize to a $T_g$ of at least −10° include methyl acrylate, methyl methacrylate, ethyl methacrylate, propyl methacrylates, butyl metharyles, bornyl acrylates, bornyl methacrylates, 2-phenoxyethyl acrylate, 2-phenoxymethyl acrylate, the mono- and di-methyl and ethyl esters of itaconic acid, and the mono- and di-methyl and ethyl esters of maleic acid. Useful acrylic ester monomers which provide reduced $T_g$ include ethyl, butyl, and octyl acrylates, and n-amyl, hexyl and octyl methacrylates. A copolymer of 43 mol percent of methyl methacrylate, 53 mol percent of methyl acrylate and 4 mol percent of acrylamide had a $T_g$ of about 50°C. A copolymer of 73 mol percent of methyl methacrylate, 19 mol percent of methyl acrylate, 4 mol percent of ethyl acrylate, and 4 mol percent of acrylamide had a $T_g$ of about 79°C.

The described hot tackifying adhesive material becomes pressure-sensitive and aggressively tacky when heated, typically for use in this invention to a temperature of about 40°C or above, and preferably 75°C or above. When later subjected to temperatures at or even above the bonding temperature, adequate bonding strength may be retained. Electrically conductive particles may be dispersed into the adhesive material to form a conductive bond, and the particles and adherends tend to be retained in their bonded position by the firm adhesive material at elevated temperatures as well as room temperature.

Other copolymerizable monomers may also be employed in small amounts without detracting from the value of the acrylic copolymer for the purposes taught in the application. Among such copolymerizable monomers are styrene, vinyl acetate and vinyl chloride, each of which can be used in amounts up to about 5 mol percent of the total monomers.

Other heat-activated adhesive materials that can be used are hot-melt adhesive materials, which are typically thermoplastic materials that soften to a flowable state and then cool to form an adhesive bond, and reactive compositions, such as epoxy-based adhesives. Sheet material in which the adhesive is pressure-sensitive at room temperature may also benefit from the present invention, i.e., by the use of electrically conductive elements in a size relationship as taught herein with the layer of pressure-sensitive adhesive on a flexible backing, especially under circumstances in which the bonded electrical connection to be made with the sheet material does not experience high ambient temperatures and pressures.

The conductive particles 14 in the sheet material of the invention shown in Figures 1 and 2 are flattened to a generally common thickness. For example, a sieved batch of originally spherical particles may be passed through nip rolls such as in a paint mill; see U.S. Pat. 3,475,213. The flattened particles are especially desirable because they tend to lie on their flattened side, and a high percentage of the particles participate in conducting electrically through the adhesive layer in an adhesive bond. Spherical particles are also useful, especially when screened within narrow size ranges so that a high percentage of the particles are of about the same size. The particles should be sufficiently firm or rigid so as to penetrate through the insulating layer during a bonding operation. The particles are usually metal, preferably silver but alternatively copper or aluminum (for which additives as described in U.S. Pat. 3,475,213 are desirable to achieve compatibility), or various other metals, metallized particles such as glass beads, carbon particles, etc. Also, electrically conductive elements may take the form of material embossed from a conductive backing, such as the embossed protrusions from a metal foil taught in U.S. Pat. 3,497,383. Or small particles clustered closely together may comprise an electrically conductive element.

The particles can range in thickness from at least 10 to 500 micrometers, though the preferred range for presently contemplated products is about 20 to 100 micrometers, and the adhesive layer can range in thickness from at least 6 to 450 micrometers. (The average thickness of the adhesive layer is determined by measuring the approximate volume of adhesive material in the layer, and dividing that volume by the area of the sheet mateerial). It is generally difficult to obtain good adhesive bonds to a substrate if the average thickness of the adhesive layer is less than about sixty percent (60%) of the average thickness of the electrically conductive elements, but lasting low-resistance electric connections are achieved in preferred constructions by making the adhesive layer significantly thinner than the electrically conductive elements, i.e., with an average thickness generally about ninety percent (90%) or less of the average thickness of the conductive elements. Best results are obtained when the average thickness of the adhesive layer is about 70 to 80 percent of the average thickness of the electrically conductive elements.

As a corollary to the above discussion, and as a further contribution to lasting low-resistance electric connections, the top edge of substantially all the electrically conductive elements in preferred constructions is higher than at least part of the adhesive layer surrounding the particles. That is, the dimension 16 of substantially each particle 14 in Figure 1 is greater than the dimension 17 of the adhesive layer at at least some points on the exterior surface of the adhesive by surrounding the particle. Preferably, the whole of substantially each particle is encircled by an area of the adhesive layer that is less high than the top edge of the electrically conductive element. Also, the electrically conductive elements are preferably substantially all separated on average by at least the average diameter of the elements, and more typically four or five times or more the average diameter, so as to allow the backing to conform around the elements during a bonding operation. On the other hand, the electrically conductive elements preferably occupy at least 2 percent, and more preferably at least 4 percent, of the area of the sheet material.

The layer 15 of electrically insulating material provides useful electrical insulation even though it should be thin, on the order of 10 micrometers in thickness over the conductive particles 14 in a construction as shown in Figures 2—3. Resistances through the layer 15 to the conductive particles of at least one megohm should be achieved. Resistance is measured by laying a test sample over a one-centimeter-square copper substrate, with the exterior surface of the insulation layer of the sample against the substrate, and laying a 500-gram weight over the test sample at room temperature. Electrical connection has previously been made between a metal conductor and the conductive layer in the test sample, e.g., the stripes 12 in the sheet material shown in Figures 1 and 2, by heat and pressure. A voltage of 5 volts is applied to the metal conductor, with the copper substrate maintained at ground, and the resistance in the circuit measured.

The insulating layer 15 preferably comprises the same or a similar material as the adhesive material 13 in which the conductive particles 14 are dispersed. The hot-tackifying adhesive taught in the previously mentioned copending application is a preferred material. One advantage is that it is adhesive over a wide temperature interval so that adhesive connections can be maintained even though the bond area has not cooled to room temperature. In some cases the insulating layer may comprise a different variety of hot-tackifying adhesive, such as a variety having a lower glass transition temperature $(T_g)$ than the adhesive material in which conductive particles are dispersed. The higher-$T_g$ adhesive material offers greater firmness at room temperature, while the lower-$T_g$ insulating layer flows readily and assists in formation of a desired adhesive bond. Other adhesive materials such as hot-melt adhesives or reactive compositions may also be used.

In the embodiment of sheet material shown in Figures 1 and 2, the particles 14 are only partially embedded in the layer of non-conducting adhesive material 13. Also, the insulating layer 15 is of a rather constant thickness and conforms to the profile left by the protruding particles. The result is that there is generally a small valley between adjacent particles, into which insulating material may advantageously be displaced during a bonding operation. The displacement of insulating material is also aided by the fact that the adhesive material 13 and particles 14 are disposed over only the electrically conductive stripes 12, thus leaving a further valley between adjacent stripes.

In less preferred embodiments of sheet material of the invention the exterior surface of the insulating layer is planar, as for example, when the conductive particles are immersed in an adhesive layer substantially as thick as the particles. Such embodiments are preferably used with terminal substrates that apply higher pressure at the locations where a bond is to be made so as to displace the insulating material. For example, the terminal pads may be slightly raised so as to apply additional pressure on the insulating and adhesive materials between the terminal pads and electrically conductive stripes or layer.

The embodiment of sheet material shown in Figure 1 and 2 illustrates another desirable feature of sheet material of the invention. That is, it is desirable for the adhesive surface of the sheet material to be profiled, with at least part of the surface of the adhesive, for example, the part that overlies spaces between the electrically conductive stripes, being recessed below other areas of the adhesive surface. Accordingly, some adhesive material in the area of the conductive stripes can be displaced during the bonding operation into the recessed areas between the stripes, and the electrically conductive elements become held in closer electrical association with the substrate. Such displacement occurs in proportion to the degree of flowability of the adhesive material and the degree of heat and pressure applied to the adhesive material during the bonding operation. A hot-tackifying adhesive material may not flow extensively during a bonding operation, so that the flexible backing may conform to the profiled thickness of the adhesive layer. Desirably recessed areas of the adhesive layer are recessed at least 10 percent and preferably at least 25 percent, below the average height of the non-recessed areas of the adhesive layer. The insulating layer 15 in the embodiment of Figure 1 and 2, is of a rather constant thickness and conforms to the profile left by the protruding particles and adhesive material 13.

After bonding to a substrate, the contact surface of sheet material of the invention generally follows the surface of the substrate. The terminal substrates with which sheet material of the invention is used may be planar, with terminal pads embedded in the substrate and coplanar with the rest of the substrate, in which case sheet material of the invention forms a generally planar full-area contact with the substrate.

Preferably, however, as discussed above, the terminal pads are slightly raised. In the finished bond the electrically conductive elements occupy a sufficient proportion of the thickness of the adhesive bond to allow any necessary dielectric breakdown through the adhesive material and achieve conduction between the conductive stripe and a substrate to which the sheet material is adhered. Preferably, the electrically conductive elements occupy a minor proportion of the area in the plane of a bond so as to leave substantial area in which adhesive contacts the adherend, and they cover a small area relative to the area of the electrically conductive stripes.

Together, the adhesive material and electrically conductive elements provide an electrically conductive adhesive layer which is conductive through the layer but not laterally within the layer. As shown in Figure 3, in some embodiments of the invention electrically conductive adhesive 20 extends over the whole surface of one side of sheet material of the invention, thereby avoiding the necessity for limited coating of the electrically conductive adhesive over only an electrically conductive stripe. Since the electrically conductive adhesive is not conductive laterally, the adjacent stripes 21 remain electrically isolated from one another. The conductive particles 22 in the electrically conductive adhesive make connection only through the adhesive layer from the electrically conductive stripe 21 to a terminal pad with which the stripe is aligned.

Another variety of sheet material of the invention shown in Figure 4 includes an electrically conductive backing 24 which extends over the full extent of the sheet material. Sheet material having such a backing, which may take the form, for example, of a metal foil or a metal-coated polymeric film, is useful for making ground connections, as between a metal chassis and a part mounted on the chassis.

Figure 5 illustrates a different embodiment of the invention in which both an insulating layer 26 and electrically conductive adhesive 27 are applied over only the electrically conductive stripes 28, and the spaces between the stripes are filled with a different adhesive 29. For example, a pressure-sensitive adhesive may be used to give the sheet material room-temperature adhesion to a substrate, which is later supplemented by heating the insulating layer and electrically conductive adhesive over the stripes 28 to an adhesive condition. Also, a hot-melt or reactive adhesive could fill the spaces between stripes.

Sheet material of the invention, especially when an elongated tape to be wound upon itself in roll form, preferably includes a low-adhesion backsize on the non-adhesive side, or a release liner disposed over the insulating layer. Also, primers may be applied to a polymeric or metallic backing to promote adhesion to an adhesive or insulating layer carried on the backing.

Sheet material of the invention is generally applied by aligning an end of the tape over the desired substrate to which connection is to be made, pressing the sheet material against the substrate, and at the same time heating the sheet material. Transfer adhesive sheet materials of the invention may be placed between desired adhesives and a bonded electrical connection made by applying heat and pressure. In such transfer adhesive sheet materials electrically conductive elements may be dispersed in an adhesive material which forms a support web for the elements, and an insulating layer may be disposed on one or both sides of the particle-containing web and the elements may protrude from both sides of the web. Alternatively, the material in which the particles is dispersed is a non-adhesive polymeric film, and adhesion is provided by the insulating layer. Similarly, the layer 13 in a product as shown in Figure 1 and 2 may be non-adhesive, e.g., because of reaction to a durable, firm state.

The invention will be further illustrated by the following examples.

Example 1

A film of polyethylene terephthalate 25 micrometers thick was vapor-coated on one surface through a slotted mask to form 875-micrometer-wide continuous stripes of silver spaced 875 micrometers apart. The stripes were approximately 400 angstroms (40 nanometers) thick and had an electrical resistance of 4 ohms per centimeter length. Electrically conductive adhesive was prepared by mixing 94.9 volume-parts of acrylic terpolymer which comprised 10.4 weight-percent methyl methacrylate, 85.6 weight-percent methyl acrylate, and 4 weight-percent acrylamide dissolved in ethyl acetate, and 5.1 volume-parts of silver particles. The particles had been sieved through a 140-mesh screen (U.S. standard; 105 micrometer mesh size) and retained on a 170-mesh screen (88 micrometers) and then passed through a roller mill to flatten the particles to approximately 48 micrometers thickness. The mixture of adhesive and particles was applied in registry over the conductive stripes by coating through an apertured mask. After drying, the adhesive terpolymer occupied a thickness of approximately 20 micrometers.

An insulating layer of acrylic terpolymer comprising 40 weight-percent ethyl acrylate, 56 weight-percent methyl acrylate, and 4 weight-percent acrylamide dissolved at about 25 weight-percent solids in ethyl acetate was then applied over the whole surface of the sheet material by bar coating, thereby covering the adhesive-coated stripes and the film backing between the stripes. After drying, a rather constant-thickness layer approximately 10 micrometers thick was formed, as shown in Figure 2. The ratio of the combined thickness of the adhesive layer and insulating layer (30 micrometers) to the average thickness of the particles was 62.5 percent.

The resistance through the layer was measured by the method described above was about 1000 megohms. For comparison a similar tape without the insulating layer was prepared and found to exhibit 10 ohms resistance.

One end of the tape of this example was adhered to the electrically conductive terminal pads of a printed circuit test board by pressing the tape against the substrate with a force of 150 pounds per square

6

inch (10.5 kilograms per square centimeter) and heating the end of the tape to a temperature of 170°C. for 5 seconds. After the connection had been allowed to cool, the resistance at the connection was measured by the four terminal resistance method and found to be 10 milliohms. The backing was roughened in the manner shown in Figure 2. The peel strength of the bond to the substrate was also measured according to ASTM D-1000 and found to be 2.5 to 5 pounds per inch width (.45 to .9 kilograms per centimeter).

Example 2

Two different tapes of the type described in Example 1 were prepared using particles having a flattened thickness of approximately 40 micrometers, sufficient adhesive material in mixture with the particles to provide an adhesive layer approximately 15 micrometers in thickness, and insulating layers of two different thicknesses—one (Example 2A) approximately 9 micrometers and the other (Example 2B) approximately 21 micrometers. The ratio of the combined thickness of the adhesive layer and insulating adhesive layers to the average particle was 60% for Example 2A and 90% for Example 2B. Pieces of tape were cut to size and bonded between the conductive pads of a printed circuit board and indium tin oxide (ITO) vapor-coated surface on a glass test panel using a pressure of 200 psi at 150°C for five seconds. The multiple connections made by each tape to the ITO test panel were monitored for individual contact resistances using a four-wire ohms method. The test panel was cycled between −40°C and 105°C every four hours. Table I below shows the results for the maximum contact resistance observed during the reported test period. The data demonstrates stable electrical performance during the stated thermal cycling for the construction using adhesive thickness in the range of 60 percent of particle thickness, and poor electrical performance when adhesive thickness is 90 percent of particle thickness. In other tests, with less temperature cycling and shorter times, tapes with a 90 percent adhesive thickness to particle thickness ratio have provided adequate stability.

TABLE I

Effects of adhesive thickness on performance in thermal age testing

| Example No. | Ratio of adh/particle thickness (%) | Maximum individual conductor bond resistance to ITO surface (ohms) | | |
|---|---|---|---|---|
| | | Initial | 100 hours | 1000 hours |
| 2A | 60 | 242 | 289 | 167 |
| 2B | 90 | 267 | >10,000 | >10,000 |

[1] The Probe Tack Value is determined as described in ASTM D-2979 except in the following respects:
1. To provide Probe Tack Values at various test temperatures, the probe and the annular weight are heated to the test temperature, except that the annular weight is never heated above 220°C.
2. The probe end is an annulus having inner and outer diameters of 3.83 and 5.10 mm.
3. The annular weight is 19.8 grams.
4. Ten-second dwell.
[2] The Shear Value is determined by heating a bright annealed stainless steel panel in an oven for 15 minutes at 115°C. above the weight-averaged $T_g$ of the adhesive polymer. With the steel panel horizontal, part of a tape 1.27 cm in width is adhered to the steel panel using a 2.04-kg hand roller conforming to Federal Standard 147, giving 2 passes in each direction. The length of tape adhering to the panel is trimmed to exactly 1.27 cm in length and this assembly is left at the bonding temperature for 15 minutes longer. The plate is transferred to an oven having a shear stand which allows a 2° backward tilt of the panel at its top (shear weight will force tape toward panel slightly). After 15 minutes at 65°C., a one-kilogram weight is hung from the free end of the tape. The time after which the weight falls is the 65°C. Shear Value.

Claims

1. Sheet material (10) adapted to make bonded electrical connections to a substrate comprising a polymeric layer (11) in which are dispersed a monolayer of discrete separated electrically conductive elements (14), characterized in that the electrically conductive elements are substantially as thick as or thicker than said layer and

a thin layer (15) of electrically insulating material is disposed over said monolayer of electrically conductive elements (14), said layer of insulating material being nontacky or poorly tacky at room temperature, providing an electrical resistance through the layer to the electrically conductive elements of at least one megohm in the test described herein, softening to an adhesive and flowable condition upon heating to an elevated temperature, and upon cooling to room temperature assuming a firm and substantially nonflowable condition, whereby the sheet material is readily handleable and free from conductive bonding at room temperature but may be pressed against said substrate and heated to make a

7

EP 0 083 503 B1

bonded connection in which said conductive elements extend through the insulating layer (15) into electrical connection with the substrate.

2. Sheet material of claim 1 which includes at least one electrically conductive layer (12) underlying said monolayer of electrically conductive elements (14).

3. Sheet material adapted to make bonded electrical connections to a substrate comprising an electrically conductive adhesive layer carried on an insulating web characterized in that the adhesive layer comprises

a non-conductive heat-activated adhesive material in which are dispersed a monolayer of discrete separated electrically conductive elements substantially as thick as or thicker than the adhesive layer; and

a thin electrically insulating layer disposed over said monolayer of electrically conductive elements, said insulating layer being nontacky or poorly tacky at room temperature, providing an electrical resistance through the layer to the electrically conductive elements, of at least one megohm in the test described herein, softening to an adhesive and flowable condition upon heating to an elevated temperature, and upon cooling to room temperature assuming a firm and substantially nonflowable condition, whereby the sheet material is readily handleable and free from conductive bonding at room temperature but may be pressed against said substrate and heated to make a bonded electrical connection in which said conductive elements extend through the insulating layer to the substrate.

4. Sheet material of claim 3 which further includes at least one electrically conductive layer supported by the insulating web, and the adhesive layer is disposed in contact with the conductive layer.

5. Sheet material of claim 4 in which there are a plurality of electrically conductive layers covering a limited portion of said insulating web.

6. Sheet material of claim 5 in which said plurality of electrically conductive layers comprise narrow parallel elongated electrically conductive stripes.

7. Sheet material of claim 5 in which the electrically conductive adhesive layer extends over only said plurality of electrically conductive layers.

8. Sheet material of claim 5 in which electrically conductive elements, are disposed over only said electrically conductive layers.

9. Sheet material of claim 5 in which electrically conductive adhesive extends over the insulating web covering both the electrically conductive layers and spaces between the layers.

10. Sheet material of claim 7, 8 or 9 in which said insulating material extends over the insulating web covering both the electrically conductive layers and spaces between the layers.

11. Sheet material as described in claim 6 in which electrically conductive adhesive is disposed over only the electrically conductive stripes; the outer surface of the electrically conductive adhesive is elevated above the outer surface of the tape between the electrically conductive stripes; and the thin layer of electrically insulating material extends over the whole web and is a substantially constant-thickness layer which follows the contour of the elevated adhesive-covered electrically conductive stripes and non-elevated areas between the stripes.

12. Sheet material of claim 7 in which a different adhesive material is dispersed between the electrically conductive layers.

13. Sheet material any of claims 5—12 in which the exterior surface of the insulating layer is contoured, with portions located above the electrically conductive layers, being higher than areas between the layers.

14. Sheet material of any of claims 1—13 in which the electrically conductive elements have an average thickness greater than the average thickness of the polymeric layer or adhesive layer, and the top edge of substantially each element is higher than at least part of the exterior surface of the polymeric or adhesive layer surrounding the element.

15. Sheet material (10) adapted to make bonded electrical connections to a substrate comprising an adhesive layer (13) which softens to an adhesive condition upon heating to an elevated temperature, and subsequently hardens to exhibit a firm and substantially nonflowable condition at room temperature; and a monolayer of discretely separated electrically conductive elements (14) dispersed in the adhesive layer; characterized in that the electrically conductive elements (14) have an average thickness greater than the average thickness of the adhesive layer (13), and the top edge of substantially each element is higher than at least part of the exterior surface of the adhesive layer surrounding the element.

16. Sheet material of claim 15 in which the average thickness of the adhesive layer is between about 60 and 90 percent of the average thickness of the electrically conductive elements (14).

17. Sheet material of claim 15 or 16 in which the electrically conductive elements are separated on average by a distance equal to at least the average diameter of the conductive elements (14).

18. Sheet material of any of claims 15 or 16 in which the average thickness of the electrically conductive elements is 100 micrometers or less, and the adhesive layer has an average thickness of 90 micrometers or less.

19. Sheet material of any of claims 15—18 which includes a flexible backing on which the adhesive layer (13) is carried.

20. Sheet material of claim 19 in which the backing is a polyester film of about 50 micrometers thickness or less.

21. Sheet material of claim 19 or 20 which includes an electrically conductive layer (14) between the flexible backing and the adhesive layer (13).

8

EP 0 083 503 B1

22. Sheet material of claim 21 which includes a plurality of electrically conductive layers in the form of narrow parallel electrically conductive stripes (12).

23. Sheet material of claim 22 in which electrically conductive elements are disposed in the adhesive layer only over the electrically conductive stripes (12).

24. Sheet material of claim 22 or 23 in which the exterior surface of the adhesive layer (13) is configured so that at least part of the exterior surface that overlies spaces between the conductive stripes (12) is recessed below other areas of the surface.

25. Sheet material of any of claims 1—24 in which the adhesive layer is a hot tackifying adhesive which exhibits a probe tack value of at least 75 grams of force at a temperature of 40°C or more.

26. Sheet material of any of claims 1—24 in which at least one of the polymerizing adhesive layer or insulating layer comprises one or more acrylic polymers and

1) acrylic ester monomer provides at least 50 mol percent of the one or more acrylic polymers of the adhesive layer,

2) said one or more acrylic polymers have a $T_g$ or a weight-averaged $T_g$ of $-10°$ to 80°C, and

3) said adhesive layer has

a) a Probe Tack Value of less than 75 gf at 20°C,

b) Probe Tack Values of at least 75 gf over a range of at least 50°C, which values remain substantially constant after 30 days at 40°C, and

c) a Shear Value of at least 25 minutes at 65°C,

said adhesive layer adheres well to a clean substrate upon contact at any temperature within said 50°C range.

27. Sheet material of claim 26 in which the adhesive layer comprises one or more acrylic copolymer of monomers, up to 50 mol % of which is at least one copolymerizable monomer selected from acrylic acid, methacrylic acid, itaconic acid, maleic acid, maleic anhydride, amides of said acids, acrylonitrile, methacrylonitrile, and N-vinyl-2-pyrrolidone.

28. Sheet material of claim 26 or 27 in which the acrylic ester monomer is selected from alkyl acrylates having 1—8 carbon atoms in their alkyl groups, alkyl methacrylates having 1—8 carbon atoms in their alkyl groups, bornyl acrylates, bornyl methacrylates, 2-phenoxy-ethyl acrylate, 2-phenoxymethyl acrylate, the mono- and dimethyl and ethyl esters of itaconic acid, and the mono- and di-methyl and ethyl esters of maleic acid.

29. Sheet material of claim 26, 27 or 28 in which at least one of styrene, vinyl acetate and vinyl chloride comprises up to 5 mol % of the total monomers.

30. Sheet material of any of claims 15—24 in which a thin layer of electrically insulating material is disposed over said monolayer of electrically conductive elements (14), said layer of insulating material being nontacky or poorly tacky at room temperature, providing an electrical resistance through the layer to the electrically conductive elements (14) of at least one megohm in the test described herein, softening to an adhesive and flowable condition upon heating to an elevated temperature, and upon cooling to room temperature assuming a firm and substantially nonflowable condition.

31. Sheet material of any of claims 2—14 in which the electrically conductive adhesive layer comprises the same monomeric ingredients as the electrically insulating layer.

32. Sheet material of any of claims 1—29 in which the exterior surface of the conductive adhesive layer is contoured, with portions of the surface being recessed at least 10 percent below other portions of the surface.

**Patentansprüche**

1. Blattmaterial (10), das zum Herstellen von stoffschlüssigen elektrischen Verbindungen mit einem Substrat geeignet ist, mit

einer polymeren Schicht (11), in der in einer Monolage angeordnete, diskrete, voneinander getrennte, elektrisch leitfähige Elemente (14) dispergiert sind, dadurch gekennzeichnet, daß die elektrisch leitfähigen Elemente im wesentlichen so dick sind wie die genannte Schicht oder dicker als diese,

daß über der Monolage aus elektrisch leitfähigen Elementen (14) eine dünne Schicht (15) aus elektrisch isolierendem Material angeordnet ist, die bei Zimmertemperatur nichtklebrig oder nur schwach klebrig ist und die bewirkt, daß in der hier beschriebenen Prüfung über die Lage zu den elektrisch leitfähigen Elementen ein elektrischer Widerstand von mindestens einem Megohm vorhanden ist, und die bei ihrem Erwärmen auf eine erhöhte Temperatur in einen klebfähigen und fließfähigen Zustand erweicht und beim Abkühlen auf Zimmertemperatur einen festen und im wesentlichen nichtfließfähigen Zustand annimmt, so daß das Blattmaterial bei Zimmertemperatur leicht manipulierbar und von leitfähigen stoffschlüssigen Verbindungen frei ist, aber derart gegen das Substrat gepreßt und erhitzt werden kann, daß eine stoffschlüssige Verbindung hergestellt wird, in der sich die leitfähigen Elemente durch die Isolierschicht (15) hindurch erstrecken und eine elektrische Verbindung mit dem Substrat herstellen.

2. Blattmaterial nach Anspruch 1 mit mindestens einer unter der Monolage aus elektrisch leitfähigen Elementen (14) angeordneten, elektrisch leitenden Schicht (12).

3. Blattmaterial, das zum Herstellen von stoffschlüssigen elektrischen Verbindungen mit einem

9

Substrat geeignet ist, mit einer von einer Isoliermaterialbahn getragenen, elektrisch leitfähigen Klebstoffschicht, dadurch gekennzeichnet, daß die Klebstoffschicht umfaßt:

einen nichtleitfähigen, wärmeaktivierbaren Klebstoff, in dem in einer Monolage angeordnete, diskrete, voneinander getrennte, elektrisch leitfähige Elemente angeordnet sind, die im wesentlichen so dick oder dicker sind als die Klebstoffschicht; und

eine über der Monolage aus elektrisch leitfähigen Elementen angeordnete, aus elektrisch isolierendem Material bestehende, dünne Schicht aus elektrisch isolierendem Material ein elektrischer Widerstand von mindestens einem Megohm vorhanden ist, und die bei ihrem Erwärmen auf eine erhöhte Temperatur in einen klebfähigen und fließfähigen Zustand erweicht und beim Abkühlen auf Zimmertemperatur einen festen und im wesentlichen nichtfließfähigen Zustand annimmt, so daß das Blattmaterial bei Zimmertemperatur leicht manipulierbar und von leitfähigen stoffschlüssigen Verbindungen frei ist, aber derart gegen das Substrat gepreßt und erhitzt werden kann, daß eine stoffschlüssige Verbindung hergestellt wird, in der sich die leitfähigen Elemente durch die Isolierschicht hindurch erstrecken und eine elektrische Verbindung mit dem Substrat herstellen.

4. Blattmaterial nach Anspruch 3, mit mindestens einer von der Isolierbahn getragenen, elektrisch leitfähigen Schicht, mit der die Klebstoffschicht in Berührung steht.

5. Blattmaterial nach Anspruch 4, dadurch gekennzeichnet, daß ein begrenzter Teil der Isoliermaterialbahn von einer Mehrzahl von elektrisch leitfähigen Schichten bedeckt ist.

6. Blattmaterial nach Anspruch 5, in dem die Mehrzahl von elektrisch leitfähigen Schichten schmale, parallele, langgestreckte, elektrisch leitfähige Streifen umfaßt.

7. Blattmaterial nach Anspruch 5, in dem die elektrisch leitfähige Klebstoffschicht sich nur über die Mehrzahl von elektrisch leitfähigen Schichten erstreckt.

8. Blattmaterial nach Anspruch 5, in dem elektrisch leitfähige Elemente nur über den elektrisch leitfähigen Schichten angeordnet sind.

9. Blattmaterial nach Anspruch 5, in dem elektrisch leitfähiger Klebstoff sich über der Isoliermaterialbahn erstreckt und sowohl die elektrisch leitfähigen Schichten als auch die Zwischenräume zwischen den Schichten bedeckt.

10. Blattmaterial nach Anspruch 7, 8 oder 9, in dem sich das genannte Isoliermaterial über der Isoliermaterialbahn erstreckt und sowohl die elektrisch leitfähigen Schichten als auch die Zwischenräume zwischen den Schichten bedeckt.

11. Blattmaterial nach Anspruch 6, in dem elektrisch leitfähiger Klebstoff nur über den elektrisch leitfähigen Streifen angeordnet ist, die Außenfläche des elektrisch leitfähigen Klebstoffes gegenüber der Außenfläche des Bandes zwischen den elektrisch leitfähigen Streifen erhaben ist und die dünne Schicht aus elektrisch isolierendem Material sich über die ganze Materialbahn erstreckt und eine Schicht bildet, die eine im wesentlichen konstante Stärke hat und der Kontur der mit dem erhabenen Klebstoff überzogen, elektrisch leitfähigen Streifen und der nichterhabenen Bereiche zwischen den Streifen folgt.

12. Blattmaterial nach Anspruch 7, in dem zwischen den elektrisch leitfähigen Schichten ein anderer Klebstoff vorgesehen ist.

13. Blattmaterial nach einem der Ansprüche 5 bis 12, dadurch gekennzeichnet, daß die Außenfläche der Isolierschicht profiliert ist und oberhalb der elektrisch leitfähigen Schichten angeordnete Teile höher sind als Bereiche zwischen den Schichten.

14. Blattmaterial nach einem der Ansprüche 1 bis 13, in dem die durchschnittliche Stärke der elektrisch leitfähigen Elemente größer ist als die durchschnittliche Stärke der polymeren Schicht oder der Klebstoffschicht und der obere Rand im wesentlichen jedes Elements höher ist als mindestens ein Teil der Außenfläche der das Element umgebenden polymeren oder Klebstoffschicht.

15. Blattmaterial (10), das zum Herstellen von stoffschlüssigen elektrischen Verbindungen mit einem Substrat geeignet ist, mit einer Klebstoffschicht (13), die bei ihrer Erwärmung auf eine erhöhte Temperatur zu einem klebfähigen Zustand erweicht und danach bei Zimmertemperatur zu einem festen, im wesentlichen nichtfließfähigen Zustand erhärtet; und mit einer Monolage aus in der Klebstoffschicht dispergierten, diskret voneinander getrennten, elektrisch leitfähigen Elementen, dadurch gekennzeichnet, daß die durchschnittliche Stärke der elektrisch leitfähigen Elemente (14) größer ist als die durchschnittliche Stärke der Klebstoffschicht (13) und daß der obere Rand im wesentlichen jedes Elements höher ist als mindestens ein Teil der Außenfläche der das Element umgebenden Klebstoffschicht.

16. Blattmaterial nach Anspruch 15, in dem die durchschnittliche Stärke der Klebstoffschicht zwischen etwa 60 und 90% der durchschnittlichen Stärke der elektrisch leitfähigen Elemente (14) beträgt.

17. Blattmaterial nach Anspruch 15 oder 16, in dem der durchschnittliche Abstand der elektrisch leitfähigen Elemente voneinander mindestens so groß ist wie der durchschnittliche Durchmesser der leitfähigen Elemente (14).

18. Blattmaterial nach einem der Ansprüche 15 oder 16, in der die durchschnittliche Stärke der elektrisch leitfähigen Elemente 100 µm oder weniger beträgt und die Klebstoffschicht eine durchschnittliche Stärke von 90 µm oder weniger hat.

19. Blattmaterial nach einem der Ansprüche 15 bis 18 mit einem flexiblen Rücken, der die Klebstoffschicht (13) trägt.

20. Blattmaterial nach Anspruch 19, in der der Rücken eine Polyesterfolie mit einer Stärke von etwa 50 µm oder weniger ist.

21. Blattmaterial nach Anspruch 19 oder 20 mit einer elektrisch leitfähigen Schicht (14) zwischen dem flexiblen Rücken und der Klebstoffschicht (13).

22. Blattmaterial nach Anspruch 21 mit einer Mehrzahl von elektrisch leitfähigen Schichten in Form von schmalen, parallelen, elektrisch leitfähigen Streifen (12).

23. Blattmaterial nach Anspruch 22, in dem elektrisch leitfähige Elemente in der Klebstoffschicht nur über den elektrisch leitfähigen Streifen (12) angeordnet sind.

24. Blattmaterial nach Anspruch 22 oder 23, in dem die Außenfläche der Klebstoffschicht (13) so geformt ist, daß mindestens ein Teil der über Zwischenräumen zwischen den leitfähigen Streifen (12) angeordneten Außenfläche gegenüber anderen Bereichen der Fläche vertieft ist.

25. Blattmaterial nach einem der Ansprüche 1 bis 24, in der die Klebstoffschicht aus einem in der Wärme klebfähig werdenden Klebstoff besteht, der bei einer Temperatur von 40°C oder mehr einer Sondenklebfähigkeit von mindestens 75 g Gewichtskraft entspricht.

26. Blattmaterial nach einem der Ansprüche 1 bis 24, in dem mindestens eine der von der polymerisierbaren Klebstoffschicht und der Isoliershicht gebildeten Schichten ein oder mehrere Acrylpolymere enthält, wobei

1) das eine oder die mehreren Acrylpolymere der Klebstoffschicht zu mindestens 50 Mol-% aus Acrylestermonomer besteht bzw. bestehen,

2) die Einfriertemperatur oder die gewichtsdurchschnittliche Einfriertemperatur des einen oder der mehreren Acrylpolymere −10 bis 80°C beträgt und

3) die Klebstoffschicht

a) bei 20°C eine Sondenklebkraft entsprechend einer Gewichtskraft von mindestens 75 g und

b) in einem Bereich von mindestens 50°C Sondenklebkräfte entsprechend einer Gewichtskraft von mindestens 75 g besitzt, wobei diese Werte nach 30 Tagen bei 40°C im wesentlichen konstant bleiben, und

c) bei 65°C eine Scherfestigkeit von mindestens 25 Minuten besitzt,

wobei die Klebstoffschicht an einem sauberen Substrat, mit dem sie bei jeder Temperatur in dem Bereich von 50°C in Berührung gebracht wird, gut haftet.

27. Blattmaterial nach Anspruch 26, in dem die Klebstoffschicht ein oder mehrere Acrylcopolymere aus Monomeren enthält, von denen bis zu 50 Mol-% aus mindestens einem copolymerisierbaren Monomer bestehen, das aus der Acrylsäure, Methacrylsäure, Itaconsäure und Maleinsäure, dem Maleinsäureanhydrid, den Amiden der genannten Säuren und dem Acrylnitril, Methacrylnitril und N-Vinyl-2-pyrrolidon ausgewählt ist.

28. Blattmaterial nach Anspruch 26 oder 27, in dem das Acrylestermonomer ausgewählt ist aus den Alkylacrylaten mit 1 bis 8 Kohlenstoffatomen in ihren Alkylgruppen, den Alkylmethacrylaten mit 1 bis 8 Kohlenstoffatomen in ihren Alkylgruppen, den Bornylacrylaten, den Bornylmethacrylaten, dem 2-Phenoxyethylacrylat, dem 2-Phenoxymethylacrylat, den Mono- und Dimethyl- und Ethylestern der Itaconsäure und den Mono- und Dimethyl- und Ethylestern der Maleinsäure ausgewählt ist.

29. Blattmaterial nach Anspruch 26, 27 oder 28, in dem die Gesamtmenge der Monomere zu mindestens 5 Mol-% aus Styrol, Vinylacetat bzw. Vinylchlorid besteht.

30. Blattmaterial nach einem der Ansprüche 25, in dem über der Monolage aus elektrisch leitfähigen Elementen (14) eine dünne Schicht aus elektrisch isolierendem Material vorgesehen ist, die bei Zimmertemperatur nichtklebfähig oder nur schwach klebfähig ist und die bewirkt, daß in der hier beschriebenen Prüfung über die Lage zu den elektrisch leitfähigen Elementen (14) ein elektrischer Widerstand von mindestens einem Megohm vorhanden ist, und die bei ihrem Erwärmen auf eine erhöhte Temperatur in einen klebfähigen und fließfähigen Zustand erweicht und beim Abkühlen auf Zimmertemperatur einen festen und im wesentlichen nichtfließfähigen Zustand annimmt.

31. Blattmaterial nach einem der Ansprüche 2 bis 14, in dem die elektrisch leitfähige Klebstoffschicht dieselben monomeren Bestandteile enthält wie die elektrisch isolierende Schicht.

32. Blattmaterial nach einem der Ansprüche 1 bis 29, in dem die Außenfläche der leitfähigen Klebstoffschicht profiliert ist und Teile der Fläche gegenüber anderen Teilen der Fläche um mindestens 10% vertieft sind.

**Revendications**

1. Matière en feuille (10) prévue pour effectuer des connexions électriques liées à un substrat, comprenant:

une couche de polymère (11) dans laquelle est dispersée une mono-couche d'éléments électriquement conducteurs séparés distincts (14), caractérisée en ce que les éléments électriquement conducteurs sont sensiblement aussi épais ou plus épais que ladite couche,

une couche mince (15) de matière électriquement isolante est disposée sur ladite monocouche d'éléments électriquement conducteurs (14), ladite couche de matière isolante étant non collante ou peu collante à température ambiante, engendrant une résistance électrique à travers la couche vers les éléments électriquement conducteurs d'au moins 1 mégohm dans l'essai décrit ici, se ramollissant à un état adhésif et d'écoulement par chauffage à une température élevée, et prenant un état solide et sensiblement sans écoulement par refroidissement à température ambiante, de sorte que la matière en feuille est facilement manipulable et ne présente pas de liaison conductrice à température ambiante mais

EP 0 083 503 B1

peut être pressée contre ledit substrat et chauffée pour effectuer une connexion collée dans laquelle lesdits éléments conducteurs traversent la couche isolante (15) et viennent en connexion électrique avec le substrat.

2. Matière en feuille suivant la revendication 1, qui comprend au moins une couche électriquement conductrice (12) placée sous ladite monocouche d'éléments électriquement conducteurs (14).

3. Matière en feuille prévue pour effectuer des connexions électriques collées à un substrat, comprenant une couche adhésive électriquement conductrice portée sur une feuille isolante, caractérisée en ce que la couche adhésive comprend:

une matière adhésive non conductrice activée par la chaleur, dans laquelle est dispersée une monocouche d'éléments électriquement conducteurs séparés distincts, sensiblement aussi épaisse ou plus épaisse que la couche adhésive; et

une couche mince électriquement isolante disposée sur ladite monocouche d'éléments électriquement conducteurs, ladite couche isolante étant non collante ou peu collante à température ambiante, engendrant une résistance électrique à travers la couche vers les éléments électriquement conducteurs, d'au moins 1 mégohm dans l'essai décrit ici, se ramollissant à un état adhésif et d'écoulement par chauffage à une température élevée, et prenant un état solide et sensiblement sans écoulement par refroidissement à la température ambiante, de sorte que la matière en feuille est facilement manipulable et ne présente pas de liaison conductrice à température ambiante mais peut être pressée contre ledit substrat et chauffée pour effectuer une connexion électrique collée dans laquelle lesdits éléments conducteurs s'étendent à travers la couche isolante jusqu'au substrat.

4. Matière en feuille suivant la revendication 3, qui comprend en outre au moins une couche électriquement conductrice supportée par la feuille isolante, et la couche adhésive est disposée en contact avec la couche conductrice.

5. Matière en feuille suivant la revendication 4, dans laquelle il y a une pluralité de couches électriquement conductrices recouvrant une partie limitée de ladite feuille isolante.

6. Matière en feuille suivant la revendication 5, dans laquelle ladite pluralité de couches électriquement conductrices comprend des bandes électriquement conductrices allongées, parallèles et étroites.

7. Matière en feuille suivant la revendication 5, dans laquelle la couche adhésive électriquement conductrice s'étend seulement sur ladite pluralité de couches électriquement conductrices.

8. Matière en feuille suivant la revendication 5, dans laquelle des éléments électriquement conducteurs sont disposés seulement sur lesdites couches électriquement conductrices.

9. Matière en feuille suivant la revendication 5, dans laquelle l'adhésif électriquement conducteur s'étend sur la feuille isolante, recouvrant à la fois les couches électriquement conductrices et les espaces entre les couches.

10. Matière en feuille suivant la revendication 7, 8 ou 9, dans laquelle ladite matière isolante s'étend sur la feuille isolante, recouvrant à la fois les couches électriquement conductrices et les espaces entre les couches.

11. Matière en feuille suivant la revendication 6, dans laquelle un adhésif électriquement conducteur est disposé seulement sur les bandes électriquement conductrices; la surface extérieure de l'adhésif électriquement conducteur est élevée au-dessus de la surface extérieure du ruban entre les bandes électriquement conductrices; et la couche mince de matière électriquement isolante s'étend sur toute la feuille et est une couche d'épaisseur sensiblement constants qui suit le contour des bandes électriquement conductrices recouvertes d'adhésif en surélévation et des zones non surélevées entre les bandes.

12. Matière en feuille suivant la revendication 7, dans laquelle une matière adhésive différente est dispersée entre les couches électriquement conductrices.

13. Matière en feuille suivant l'une quelconque des revendications 5 à 12, dans laquelle la surface extérieure de la couche isolante est profilée, les parties situées au-dessus de couches électriquement conductrices étant plus hautes que les régions entre les couches.

14. Matière en feuille suivant l'une quelconque des revendications 1 à 13, dans laquelle les éléments électriquement conducteurs ont une épaisseur moyen ne supérieure à l'épaisseur moyenne de la couche de polymère ou de la couche adhésive, et le bord supérieur de sensiblement chaque élément est plus haut qu'au moins une partie de la surface extérieure de la couche de polymère ou d'adhésif entourant l'élément.

15. Matière en feuille (10) prévue pour effectuer des connexions électriques collées à un substrat, comprenant une couche adhésive (13) qui se rammollit à un état adhésif par chauffage à une température élevée et qui durcit ensuite pour prendre un état solide et sensiblement sans écoulement à température ambiante; et une monocouche d'éléments électriquement conducteurs distinctement séparés (14), dispersés dans la couche adhésive; caractérisée en ce que les éléments électriquement conducteurs (14) ont une épaisseur moyenne supérieure à l'épaisseur moyenne de la couche adhésive (13), et le bord supérieur de sensiblement chaque élément est plus haut qu'au moins une partie de la surface extérieure de la couche adhésive entourant l'élément.

16. Matière en feuille suivant la revendication 15, dans laquelle l'épaisseur moyenne de la couche adhésive est comprise entre 60% et 90% environ de l'épaisseur moyenne des éléments électriquement conducteurs (14).

17. Matière en feuille suivant la revendication 15 ou 16, dans laquelle les éléments électriquement conducteurs sont séparés en moyenne d'une distance égale au moins au diamètre moyen des éléments conducteurs (14).

18. Matière en feuille suivant l'une quelconque des revendications 15 ou 16, dans laquelle l'épaisseur moyenne des éléments électriquement conducteurs est de 100 µm ou moins, et la couche adhésive a une épaisseur moyenne de 90 µm ou moins.

19. Matière en feuille suivant l'une quelconque des revendications 15 à 18, qui comprend un support flexible sur lequel est portée la couche adhésive (13).

20. Matière en feuille suivant la revendication 19, dans laquelle le support est un film de polyester d'une épaisseur de 50 µm environ ou moins.

21. Matière en feuille suivant la revendication 19 ou 20, qui comprend une couche électriquement conductrice entre le support flexible et la couche adhésive (13).

22. Matière en feuille suivant la revendication 21, qui comprend une pluralité de couches électriquement conductrices sous la forme de bandes électriquement conductrices, parallèles et étroites (12);

23. Matière en feuille suivant la revendication 22, dans laquelle les éléments électriquement conducteurs sont disposés dans la couche adhésive seulement au-dessus des bandes électriquement conductrices (12).

24. Matière en feuille suivant la revendication 22 ou 23, dans laquelle la surface extérieure de la couche adhésive (13) est configurée de sorte qu'au moins une partie de la surface extérieure qui est située au-dessus des espaces entre les bandes conductrices (12) est en retrait au-dessous des autres régions de la surface.

25. Matière en feuille suivant l'une quelconque des revendications 1 à 24, dans laquelle la couche adhésive est un adhésif collant à chaud qui possède une valeur de collage de sonde d'au moins 0,75 N à une température de 40°C ou plus.

26. Matière en feuille suivant l'une quelconque des revendications 1 à 24, dans laquelle au moins l'une de la couche adhésive polymérisable ou de la couche isolante comprend un ou plusieurs polymères acryliques et

1) un monomère d'ester acrylique représente au moins 50 mol % desdits un ou plusieurs polymères acryliques de la couche adhésive,

2) lesdits un ou plusieurs polymères acryliques ont un $T_g$ ou un $T_g$ pondéré de −10°C à 80°C, et

3) ladite couche adhésive a

a) une Valeur de Collage de Sonde inférieure à 0,75 N à 20°C,

b) des Valeurs de Collage de Sonde d'au moins 0,75 N dans une plage d'au moins 50°C, ces valeurs restant sensiblement constantes après 30 jours à 30°C, et

c) une Valeur de Cisaillement d'au moins 25 minutes à 65°C, ladite couche adhésive adhère bien à un substrat propre par contact à toute température dans ladite plage de 50°C.

27. Matière en feuille suivant la revendication 26, dans laquelle la couche adhésive comprend un ou plusieurs copolymères acryliques de monomères, dont jusqu'à 50 mol % sont constitués d'au moins un monomère copolymérisable choisi parmi les acide acrylique, acide méthacrylique, acide itaconique, acide maléique, anhydride maléique amides desdits acides, acrylonitrile, méthacrylonitrile, et N-vinyl-2-pyrrolidone.

28. Matière en feuille suivant la revendication 26 ou 27, dans laquelle le monomère d'ester acrylique est choisi parmi les acrylates d'alkyle comportant 1 à 8 atomes de carbone dans leurs groupes alkyle, les méthacrylates d'alkyle comportant 1 à 8 atomes de carbone dans leurs groupes alkyle, les acrylates de bornyle, les méthacrylates de bornyle, l'acrylate de 2-phénoxyéthyle, l'acrylate de 2-phénoxyméthyle, les mono- et di-méthyl- et éthyl-esters de l'acide itaconique, et les mono- et di-méthyl et éthylesters d'acide maléique.

29. Matière en feuille suivant la revendication 26, 27 ou 28 dans laquelle au moins l'un du styrène, de l'acétate de vinyle et du chlorure de vinyle constitue jusqu'à 5 mol % des monomères totaux.

30. Matière en feuille suivant l'une quelconque des revendications 15 à 24, dans laquelle une couche mince de matière électriquement isolante est disposée sur ladite monocouche d'éléments électriquement conducteurs (14), ladite couche de matière isolante étant non collante ou peu collante à température ambiante, procurant une résistance électrique à travers la couche vers les éléments électriquement conducteurs (14) d'au moins 1 mégohm dans l'essai décrit ici, se ramollissant à un état adhésif et d'écoulement par chauffage à une température élevée, et prenant un état solide et sensiblement sans écoulement par refroidissement à la température ambiante.

31. Matière en feuille suivant l'une quelconque des revendications 2 à 14, dans laquelle la couche adhésive électriquement conductrice comprend les mêmes ingrédients monomères que la couche électriquement isolante.

32. Matière en feuille suivant l'une quelconque des revendications 1 à 29, dans laquelle la surface extérieure de la couche adhésive conductrice présente une configuration telle que des parties de la surface sont en retrait d'au moins 10% au-dessous des autres parties de la surface.

**FIG.1**

**FIG.2**

**FIG.3**

**FIG.4**

**FIG.5**

1